(19) Europäisches Patentamt / European Patent Office / Office européen des brevets

(11) **EP 3 264 446 B1**

(12) **EUROPEAN PATENT SPECIFICATION**

(45) Date of publication and mention of the grant of the patent:
**27.11.2019 Bulletin 2019/48**

(51) Int Cl.:
**H01L 21/225** *(2006.01)*    **H01L 31/18** *(2006.01)*

(21) Application number: **16755221.5**

(22) Date of filing: **10.02.2016**

(86) International application number:
**PCT/JP2016/053974**

(87) International publication number:
**WO 2016/136474 (01.09.2016 Gazette 2016/35)**

(54) **P-TYPE IMPURITY DIFFUSION COMPOSITION, METHOD FOR MANUFACTURING SEMICONDUCTOR ELEMENT USING SAID COMPOSITION, AND METHOD FOR MANUFACTURING A SOLAR CELL**

DIFFUSIONSZUSAMMENSETZUNGEN FÜR P-TYP-VERUNREINIGUNGEN, VERFAHREN ZUR HERSTELLUNG EINES HALBLEITERBAUELEMENTS UNTER VERWENDUNG DIESER ZUSAMMENSETZUNG, VERFAHREN ZUR HERSTELLUNG EINER SOLARZELLE

COMPOSITION DE DIFFUSION D'IMPURETÉS DE TYPE P, PROCÉDÉ DE FABRICATION D'ÉLÉMENT SEMI-CONDUCTEUR À L'AIDE DE CETTE COMPOSITION, ET PROCÉDÉ DE FABRICATION D'UNE CELLULE SOLAIRE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **25.02.2015   JP 2015034924**
**17.09.2015   JP 2015183672**

(43) Date of publication of application:
**03.01.2018 Bulletin 2018/01**

(73) Proprietor: **Toray Industries, Inc.**
**Tokyo 103-8666 (JP)**

(72) Inventors:
- **IKEGAMI, Yoshihiro**
  **Otsu-shi**
  **Shiga 520-8558 (JP)**
- **MURASE, Seiichiro**
  **Otsu-shi**
  **Shiga 520-8558 (JP)**
- **INABA, Sachio**
  **Otsu-shi**
  **Shiga 520-8558 (JP)**

(74) Representative: **Hoefer & Partner Patentanwälte mbB**
**Pilgersheimer Straße 20**
**81543 München (DE)**

(56) References cited:
**WO-A1-2006/117975      WO-A1-2012/144292**
**WO-A1-2015/002132      WO-A1-2015/002132**
**WO-A2-2011/028034      JP-A- S62 226 671**

**Description**

TECHNICAL FIELD

The present invention relates to a p-type impurity-diffusing composition for diffusing p-type impurities into a semiconductor substrate, and a method of manufacturing a semiconductor device using the composition, a solar cell, and a method of manufacturing the solar cell.

BACKGROUND ART

In the current production of solar cells, when a p-type or n-type impurity diffusion layer is formed in a semiconductor substrate, a method is used in which a diffusion source is formed on the substrate, and impurities are diffused into the semiconductor substrate by thermal diffusion. To form the diffusion source, chemical vapor deposition (CVD) or solution coating of a liquid impurity-diffusing composition have been studied. Of these, the solution coating is preferably used because it does not require high cost facilities and is excellent in manufacturability. In the solution coating, when a p-type impurity diffusion layer is formed, a coating solution containing boron is usually applied to the surface of the semiconductor substrate using a spin coater, screen printing or the like, and then thermally diffused.

A conventional coating solution uses an ethylene glycol solvent having excellent solubility in boron, for example, ethylene glycol monomethyl ether, as a solvent. The ethylene glycol solvent is, however, highly toxic and is to be environmentally controlled, so that it is difficult to be used. Therefore, there has been proposed a coating solution that uses a propylene glycol solvent as an alternative solvent of ethylene glycol and to which a nonionic surfactant is further added (e.g., see Patent Document 1).

PRIOR ART DOCUMENT

PATENT DOCUMENT

Patent Document 1: JP 9-181010 A

The document WO2015002132 refers to a doping composition which can include a group 13 element.

SUMMARY OF THE INVENTION

PROBLEMS TO BE SOLVED BY THE INVENTION

The coating solution mainly using a propylene glycol solvent, however, has poor storage stability, and there has been difficult to control coating thickness and diffusion concentration in order to gradually thicken the solution.

The present invention is made in view of the circumstances described above and aims to provide a p-type impurity-diffusing composition that can improve storage stability of the coating solution and achieve uniform diffusion to a semiconductor substrate.

SOLUTIONS TO THE PROBLEMS

To solve the problems described above, the p-type impurity-diffusing composition of the present invention has the following structure: In other words, it is a p-type impurity-diffusing composition which contains a group 13 element-containing compound (A), a hydroxyl group-containing polymer (B), and an organic solvent (C), in which the organic solvent (C) contains a cyclic ester solvent (C1).

EFFECTS OF THE INVENTION

The present invention can provide a p-type impurity-diffusing composition that is excellent in storage stability and also excellent in uniformity of impurity diffusion to a substrate.

BRIEF DESCRIPTION OF THE DRAWINGS

FIG. 1 is a cross-sectional process view illustrating a first example of the method of forming an impurity diffusion layer using the p-type impurity-diffusing composition of the present invention.

FIG. 2 is a cross-sectional process view illustrating a second example of the method of forming an impurity diffusion layer using the p-type impurity-diffusing composition of the present invention.

FIG. 3 is a cross-sectional process view illustrating a third example of the method of forming an impurity diffusion layer using the p-type impurity-diffusing composition of the present invention.

FIG. 4 is a cross-sectional process view illustrating a fourth example of the method of forming an impurity diffusion layer using the p-type impurity-diffusing composition of the present invention.

FIG. 5 is a cross-sectional process view illustrating an example of the method of manufacturing a double side power generation type solar cell using the p-type impurity-diffusing composition of the present invention.

## EMBODIMENTS OF THE INVENTION

Hereinafter, the embodiments of the present invention will be described. The following embodiments are provided by way of illustration and are not intended to limit the invention.

The p-type impurity-diffusing composition of the present invention contains a group 13 element-containing compound (A), a hydroxyl group-containing polymer (B), and an organic solvent (C), in which the organic solvent (C) contains a cyclic ester solvent (C1).

(A) Group 13 Element-Containing Compound

In the p-type impurity-diffusing composition of the present invention, the group 13 element-containing compound (A) is a component for forming a p-type impurity diffusion layer in a semiconductor substrate. Examples of the group 13 element-containing compound (A) include a boron compound, an aluminum compound, and a gallium compound. Of these, a boron compound is preferable.

Specific examples of boron compounds include boric acids such as boric acid and boron oxide; borates such as ammonium borate; halides such as boron trifluoride, boron trichloride, boron tribromide, and boron triiodide; boronic acids such as methyl borate and phenyl borate; and boric acid esters such as trimethyl borate, triethyl borate, tripropyl borate, tributyl borate, trioctyl borate, and triphenyl borate. Of these, boric acids, boronic acids, and boric acid esters are preferable, boric acids are more preferable, and boric acid and boron oxide are even more preferable, in terms of ease of handing.

The content of the group 13 element-containing compound (A) in the p-type impurity-diffusing composition can be arbitrarily determined by a resistance value required for the semiconductor substrate, and is preferably in the range of 0.1 to 10% by mass relative to the total mass of the p-type impurity-diffusing composition.

(B) Hydroxyl Group-Containing Polymer

In the p-type impurity-diffusing composition of the present invention, the hydroxyl group-containing polymer (B) forms a complex with the group 13 element-containing compound (A), particularly preferably a boron compound and is a component for forming a uniform film during coating.

Specific examples of the hydroxyl group-containing polymer (B) include polyvinyl alcohol resin (B1) such as polyvinyl alcohol and modified polyvinyl alcohol; vinyl alcohol derivative such as polyvinyl acetal and polyvinylbutyral; polyalkylene oxide such as polyethylene oxide (B2) and polypropylene oxide; polyhydroxy acrylic acrylates such as hydroxyethyl cellulose, polyhydroxymethyl acrylate, polyhydroxyethyl acrylate, and polyhydroxypropyl acrylate. Of these, the polyvinyl alcohol resin (B1) and the polyethylene oxide (B2) are preferable in terms of formation of a complex with the group 13 element-containing compound (A), particularly preferably a boron compound, stability of the formed complex, and storage stability of the p-type impurity-diffusing composition. These can be used alone or in combination of two or more kinds.

In the p-type impurity-diffusing composition of the present invention, the hydroxyl group-containing polymer (B) contains the polyvinyl alcohol resin (B1) and the polyethylene oxide (B2), and the content ratio (mass ratio) of the polyvinyl alcohol resin (B1) and the polyethylene oxide (B2) is preferably expressed by (B1): (B2)=(60:40) to (30:70) . By the combined use of the polyvinyl alcohol resin (B1) and the polyethylene oxide (B2), the storage stability of the p-type impurity-diffusing composition is easily improved. Further, as for the content ratio (mass ratio) of the polyvinyl alcohol resin (B1) and the polyethylene oxide (B2), when the content ratio of the polyvinyl alcohol resin (B1) is 60% by mass or less, the p-type impurity-diffusing composition is less likely to be gelled, which tends to further improve storage stability. When the content ratio of the polyvinyl alcohol resin (B1) is 30% by mass or more, the formation of a complex with the group 13 element-containing compound (A), particularly preferably a boron compound and the stability of the formed complex are further improved, which tends to further improve diffusion uniformity.

The polyvinyl alcohol resin (B1) preferably has an average polymerization degree of 150 to 1000. Further, the polyvinyl alcohol resin (B1) preferably has a saponification degree of 60 to 100% by mole in terms of solubility and complex stability. In the present invention, both the average polymerization degree and the saponification degree are values measured in accordance with JIS K6726(1994), and the saponification degree is a value measured by a back titration method.

The polyethylene oxide (B2) has preferably a viscosity average molecular weight of 15000 to 1500000. The viscosity average molecular weight in the above range can enhance the compatibility with the polyvinyl alcohol resin (B1).

The viscosity average molecular weight of the polyethylene oxide (B2) is determined using the following formula for viscosity.

[Mathematical Formula 1]

$$[\eta] = K \times \mathrm{M}^{\mathrm{a}}$$

In the above formula, $[\eta]$ represents a limiting viscosity; K and a represent coefficients determined depending on the solvent and the type of polymer; and M represents a viscosity average molecular weight.

Here, using an Ostwald viscometer, specific viscosity $\eta^{sp}$ of an aqueous polyethylene oxide solution having various concentrations c (g/dl) in pure water is measured at 35°C, and the specific viscosity thus measured is divided by the concentration to give a reduced viscosity ($\eta^{sp}/c$). Based on the relationship between the reduced viscosity ($\eta^{sp}/c$) and the concentration c, the concentration c is extrapolated to 0 to thereby calculate a limiting viscosity $[\eta]$. Next, as values K and a of polyethylene oxide in pure water, $6.4 \times 10\text{-}5$ (dl/g) and 0.82 are applied, respectively, to determine a viscosity average molecular weight of polyethylene oxide.

The amount of the hydroxyl group-containing polymer (B) contained in the p-type impurity-diffusing composition is preferably in the range of 0.1 to 20% by mass relative to the total mass of the p-type impurity-diffusing composition. The amount thereof is more preferably in the range of 0.5 to 15% by mass. When the amount is within the above range, a coating film after coating has more excellent uniformity.

(C) Organic Solvent

In the p-type impurity-diffusing composition of the present invention, the organic solvent (C) contains a cyclic ester solvent (C1). The cyclic ester solvent (C1) is a component for suppressing increase of viscosity of the p-type impurity-diffusing composition. The action thereof is considered as follows.

In the p-type impurity-diffusing composition, the group 13 element-containing compound (A), particularly preferably a boron compound, and the hydroxyl group-containing polymer (B), particularly preferably the polyvinyl alcohol resin (B1) or the polyethylene oxide (B2) form complexes. By containing the cyclic ester solvent (C1), the complex of the group 13 element-containing compound (A) and the hydroxyl group-containing polymer (B) improves its stability. As a result of this, an event such that the group 13 element-containing compound (A) and the hydroxyl group-containing polymer (B) that have already formed a complex are further reacted to form a three-dimensional complex can be avoided, and thickening of the p-type impurity-diffusing composition over time or generation of a gel-like foreign substance due to the thickening can be prevented. Therefore, when the p-type impurity-diffusing composition of the present invention is used for coating, the coating thickness becomes uniform, and in the subsequent impurity diffusion process, uniform impurity diffusion can be achieved.

Specific examples of the cyclic ester solvent (C1) include lactone-based solvents such as β-propiolactone, β-butyrolactone, γ-butyrolactone, γ-valerolactone, δ-valerolactone, γ-caprolactone, ε-caprolactone, γ-octalactone, γ-nonalactone, γ-decanolactone, δ-decanolactone, γ-undecalactone, δ-undecalactone, ω-undecalactone, and ω-pentadecalactone. Of these, γ-butyrolactone is particularly preferable from the viewpoint of compatibility with the hydroxyl group-containing polymer (B) . These cyclic ester solvents (C1) can be used alone or as a mixed solvent of two or more kinds.

Further, the p-type impurity-diffusing composition of the present invention may contain an organic solvent other than the cyclic ester solvent (C1). Specific examples thereof include alcohols such as methanol, ethanol, propanol, isopropanol, butanol, isobutanol, t-butanol, 1-methoxy-2-propanol, pentanol, 4-methyl-2-pentanol, 3-methyl-2-butanol, 3-methyl-3-methoxy-1-butanol, 1-t-butoxy-2-propanol, diacetone alcohol, terpineol, and texanol; glycols such as ethylene glycol, propylene glycol, diethylene glycol, triethylene glycol, 1,3-butanediol, and 1,4-butanediol; ethers such as ethylene glycol monomethyl ether, ethylene glycol monoethyl ether, propylene glycol monomethyl ether, propylene glycol monoethyl ether, propylene glycol monopropyl ether, propylene glycol t-butyl ether, propylene glycol n-butyl ether ethylene glycol dimethyl ether, ethylene glycol diethyl ether, ethylene glycol dibutyl ether, diethyl ether, diethylene glycol methyl ethyl ether, dipropylene glycol-n-butyl ether, dipropylene glycol monomethyl ether, diisopropyl ether, di-n-butyl ether, diphenyl ether, diethylene glycol ethyl methyl ether, diethylene glycol dimethyl ether, and ethylene glycol monobutyl ether; ketones such as methyl ethyl ketone, acetylacetone, methyl propyl ketone, methyl butyl ketone, methyl isobutyl ketone, diisobutyl ketone, cyclopentanone, 2-heptanone, diisobutyl ketone, cyclohexanone, and cycloheptanone; amides such as dimethylformamide and dimethylacetamide; acetates such as isopropyl acetate, ethyl acetate, propyl acetate, butyl acetate, n-propyl acetate, isopropyl acetate, n-butyl acetate, isobutyl acetate, ethyl acetoacetate, ethylene glycol monomethyl ether acetate, ethylene glycol monoethyl ether acetate, diethylene glycol monoethyl ether acetate, propylene glycol monomethyl ether acetate, 3-methoxybutyl acetate, 3-methyl-3-methoxybutyl acetate, butyl diglycol acetate, 1,3-butylene glycol diacetate, ethyl diglycol acetate, dipropylene glycol methyl ether acetate, methyl lactate, ethyl lactate, butyl lactate, and triacetyl glycerin; aromatic or aliphatic hydrocarbons such as toluene, xylenes, hexane, cyclohexane, ethyl benzoate, naphthalene, and 1,2,3,4-tetrahydronaphthalene; and N-methyl-2-pyrrolidone, N,N-dimethylimidazolidinone, dimethyl sulfoxide, and propylene carbonate.

When the hydroxyl group-containing polymer (B) is dissolved in water, an organic solvent and water may be used by mixing.

These organic solvents and water can be used alone or as a mixed solvent of two or more kinds.

In the p-type impurity-diffusing composition of the present invention, the content of the cyclic ester solvent (C1) in the organic solvent (C) is preferably in the range of 70 to 100% by mass. When the content thereof is within the above range, increase in viscosity of the p-type impurity-diffusing composition can be more effectively suppressed.

The p-type impurity-diffusing composition of the present invention can contain a surfactant. Containing a surfactant provides a more uniform coating film with improved unevenness. Preferred surfactants are fluorochemical surfactants and silicone surfactants.

Specific examples of fluorochemical surfactants include fluorochemical surfactants including a compound having a fluoroalkyl group or a fluoroalkylene group at least one of terminals, the main chain, and the side chain, such as 1,1,2,2-tetrafluorooctyl(1,1,2,2-tetrafluoropropyl) ether, 1,1,2,2-tetrafluorooctylhexyl ether, octaethylene glycol di(1,1,2,2-tetrafluorobutyl) ether, hexaethylene glycol (1,1,2,2,3,3-hexafluoropentyl) ether, octapropylene glycol di(1,1,2,2-tetrafluorobutyl) ether, hexapropylene glycol di(1,1,2,2,3,3-hexafluoropentyl) ether, sodium perfluorododecylsulfonate, 1,1,2,2,8,8,9,9,10,10-decafluorododecane, 1,1,2,2,3,3-hexafluorodecane, N-[3-(perfluorooctanesulfonamide)propyl]-N,N'-dimethyl-N-ca rboxymethylene ammonium betaine, perfluoroalkylsulfonamide propyltrimethylammonium salt, perfluoroalkyl-N-ethylsulfonylglycine salt, bis(N-perfluorooctylsulfonyl-N-ethylaminoethyl) phosphate, and monoperfluoroalkyl ethylphosphoric acid ester. Examples of commercially available products thereof include fluorochemical surfactants such as MEGAFACE F142D, MEGAFACE F172, MEGAFACE F173, MEGAFACE F183, MEGAFACE F444, MEGAFACE F475, MEGAFACE F477 (manufactured by Dainippon Ink And Chemicals, Incorporated), EFTOP EF301, EFTOP EF303, EFTOP EF352 (manufactured by Shin-Akita Kasei K.K.), Fluorad FC-430, Fluorad FC-431 (manufactured by Sumitomo 3M Limited), AsahiGuard AG710, Surflon S-382, Surflon SC-101, Surflon SC-102, Surflon SC-103, Surflon SC-104, Surflon SC-105, Surflon SC-106 (manufactured by Asahi Glass Co., Ltd.), BM-1000, BM-1100 (manufactured by Yusho Co., Ltd.), and NBX-15, FTX-218, DFX-218 (manufactured by NEOS COMPANY LIMITED).

Examples of commercially available products of silicone surfactants include SH28PA, SH7PA, SH21PA, SH30PA, and ST94PA (manufactured by Dow Corning Toray Co., Ltd.), and BYK067A, BYK310, BYK322, BYK331, BYK333, and BYK355 (manufactured by BYK-Chemie Japan).

The content of the surfactant is preferably in the range of 0.01 to 1% by mass relative to the total mass of the p-type impurity-diffusing composition. When the content is within the above range, a coating film having especially high uniformity can be obtained.

When the p-type impurity-diffusing composition of the present invention is used in printing such as screen printing, a viscosity control agent such as a thickener or a thixotropic agent can be contained for viscosity control. The viscosity control agent enables an application in a finer pattern in printing such as screen printing.

Examples of thickeners include organic thickeners such as celluloses including cellulose and ethyl cellulose; starch, starch derivatives, polyvinylpyrrolidone, polyvinyl acetate, polyurethane resins, polyurea resins, polyimide resins, polyamide resins, epoxy resins, polystyrene resins, polyester resins, synthetic rubber, natural rubber, and polyacrylic acid; polyacrylates such as polymethyl methacrylate, polyethyl methacrylate, polypropyl methacrylate, polybutyl methacrylate, polymethyl acrylate, polyethyl acrylate, polypropyl acrylate, polybutyl acrylate, polybenzyl methacrylate, and polyglycidyl methacrylate, and copolymers thereof; silicone oil, sodium alginate, xanthan gum polysaccharides, gellan gum polysaccharides, guar gum polysaccharides, carrageenan polysaccharides, locust bean gum polysaccharides, carboxy vinyl polymer, hydrogenated castor oil-based ones, mixtures of hydrogenated castor oil-based one and fatty acid amide wax-based one, special fatty acid-based ones, polyethylene oxide-based ones, mixtures of polyethylene oxide-based one and amide-based one, fatty acid-based polycarboxylic acids, phosphate surfactants, salts of long-chain polyaminoamide and phosphoric acid, and specially modified polyamide-based ones;

and inorganic thickeners such as bentonite, montmorillonite, magnesian montmorillonite, iron montmorillonite, iron magnesian montmorillonite, beidellite, alumine beidellite, saponite, aluminian saponite, laponite, aluminum silicate, magnesium aluminum silicate, organic hectorite, silicon oxide fine particles, colloidal alumina, and calcium carbonate. These may be used in combination of two or more.

Examples of commercially available products include cellulose thickeners such as 1110, 1120, 1130, 1140, 1150, 1160, 1170, 1180, 1190, 2200, 2260, 2280, 2450 (all manufactured by Daicel Finechem Ltd.).

Examples of commercially available products include polysaccharides thickeners such as Viscarin PC209, Viscarin PC389, SeaKem XP8012 (manufactured by FMC Chemicals Inc.), and CAM-H, GJ-182, SV-300, LS-20, LS-30, XGT, XGK-D, G-100, LG-10 (all manufactured by Mitsubishi Corporation).

Examples of commercially available products include acrylic thickeners such as #2434T, KC7000, KC1700P (manufactured by Kyoeisha Chemical Co., Ltd.), and AC-10LHPK, AC-10SHP, 845H, PW-120 (manufactured by Toagosei Co., Ltd.).

Examples of commercially available products include hydrogenated castor oil-based thickeners such as DISPARLON 308, NAMLONT-206 (manufactured by Kusumoto Chemicals, Ltd.), and T-20SF, T-75F (manufactured by Itoh Oil Chemicals Co., Ltd.); and polyethylene oxide thickeners such as D-10A, D-120, D-120-10, D-1100, DS-525, DS-313 (manufactured by Itoh Oil Chemicals Co., Ltd.), DISPARLON 4200-20, DISPARLON PF-911, DISPARLON PF-930, DISPARLON 4401-25X, DISPARLON NS-30, DISPARLON NS-5010, DISPARLON NS-5025, DISPARLON NS-5810, DISPARLON NS-5210, DISPARLON NS-5310 (manufactured by Kusumoto Chemicals, Ltd.), and FLOWNON SA-300, FLOWNON SA-300H (manufactured by Kyoeisha Chemical Co., Ltd.).

Examples of commercially available products include amide thickeners such as T-250F, T-550F, T-850F, T-1700, T-1800, T-2000 (manufactured by Itoh Oil Chemicals Co., Ltd.), DISPARLON 6500, DISPARLON 6300, DISPARLON 6650, DISPARLON 6700, DISPARLON 3900EF (manufactured by Kusumoto Chemicals, Ltd.), and TALEN 7200, TALEN 7500, TALEN 8200, TALEN 8300, TALEN 8700, TALEN 8900, TALEN KY-2000, KU-700, TALEN M-1020, TALEN VA-780, TALEN VA-750B, TALEN 2450, FLOWNON SD-700, FLOWNON SDR-80, FLOWNON EC-121 (manufactured by Kyoeisha Chemical Co., Ltd.).

Examples of commercially available products include bentonite thickeners such as BEN-GEL, BEN-GEL HV, BEN-GEL HVP, BEN-GEL F, BEN-GEL FW, BEN-GEL BRIGHT 11, BEN-GEL A, BEN-GEL W-100, BEN-GEL W-100U, BEN-GEL W-300U, BEN-GEL SH, MULTI-BEN, S-BEN, S-BEN C, S-BEN E, S-BEN W, S-BEN P, S-BEN WX, ORGANITE, ORGANITE D (manufactured by HOJUN., Co., Ltd.).

Examples of commercially available products include silicon oxide fine particle thickeners such as AEROSIL R972, AEROSIL R974, AEROSIL NY50, AEROSIL RY200S, AEROSIL RY200, AEROSIL RX50, AEROSIL NAX50, AEROSIL RX200, AEROSIL RX300, AEROSIL VPNKC130, AEROSIL R805, AEROSIL R104, AEROSIL R711, AEROSIL OX50, AEROSIL 50, AEROSIL 90G, AEROSIL 130, AEROSIL 200, AEROSIL 300, AEROSIL 380 (manufactured by Nippon Aerosil Co., Ltd.), and WACKER HDK S13, WACKER HDK V15, WACKER HDK N2 0, WACKER HDK N20P, WACKER HDK T30, WACKER HDK T40, WACKER HDK H15, WACKER HDK H18, WACKER HDK H20, WACKER HDK H30 (manufactured by Asahi Kasei Corporation).

Specific examples of thixotropic agents include celluloses such as cellulose and ethyl cellulose, sodium alginate, xanthan gum polysaccharides, gellan gum polysaccharides, guar gum polysaccharides, carrageenan polysaccharides, locust bean gum polysaccharides, carboxy vinyl polymer, hydrogenated castor oil-based ones, mixtures of hydrogenated castor oil-based one and fatty acid amide wax-based one, special fatty acid-based ones, polyethylene oxide-based ones, mixtures of polyethylene oxide-based one and amide-based one, fatty acid-based polycarboxylic acids, phosphate surfactants, salts of long-chain polyaminoamide and phosphoric acid, specially modified polyamide-based ones, bentonite, montmorillonite, magnesian montmorillonite, iron montmorillonite, iron magnesian montmorillonite, beidellite, alumine beidellite, saponite, aluminian saponite, laponite, aluminum silicate, magnesium aluminum silicate, organic hectorite, silicon oxide fine particles, colloidal alumina, and calcium carbonate. The thixotropic agents may be used alone, and two or more thixotropic agents may also be combined. The thixotropic agent can be used in combination with the above-described thickeners.

The content of the viscosity control agent is preferably in the range of 0.1 to 10% by mass relative to the total mass of the p-type impurity-diffusing composition. The viscosity control agent in this range produces a sufficient viscosity control effect.

The viscosity of the p-type impurity-diffusing composition of the present invention is not limited and can be appropriately varied according to the coating method and the film thickness.

For example, in the case of spin coating, a preferred coating method, the viscosity of the p-type impurity-diffusing composition is preferably in the range of 1 to 100 mPa•s, and more preferably 1 to 50 mPa•s. In the present invention, the viscosity, when being less than 1,000 mPa•s, is a value determined in accordance with JIS Z 8803 (1991) "Methods for viscosity measurement of solution" using an E-type digital viscometer at a rotation speed of 5 rpm, and the viscosity, when being 1,000 mPa•s or more, is a value determined in accordance with JIS Z 8803 (1991) "Methods for viscosity measurement of solution" using a B-type digital viscometer at a rotation speed of 20 rpm.

For example, in the case of screen printing, another preferred coating method, it is preferable that the p-type impurity-diffusing composition has a viscosity in the range of 3000 to 15000 mPa•s and a thixotropic index of 1.1 to 1.7. In the present invention, the term "thixotropic index" (hereinafter expressed as TI value in some cases) refers to a ratio (2 rpm/20 rpm) of the viscosity at a rotation speed of 2 rpm to the viscosity at a rotation speed of 20 rpm, measured using a B-type digital viscometer. The viscosity and TI value of the p-type impurity-diffusing composition in the above ranges easily provide good printing pattern.

The solids concentration of the p-type impurity-diffusing composition of the present invention is not particularly limited and preferably in the range of 1 to 50% by mass, and more preferably 1 to 25% by mass. The solids concentration in this range provides especially good storage stability and easy control of the coating thickness, so that a desired diffusion concentration can be easily achieved. The term "solids" herein refers to all the components except the solvent in the p-type impurity-diffusing composition.

<Method of Manufacturing a Semiconductor Device>

The method of forming an impurity diffusion layer using the p-type impurity-diffusing composition of the present invention and a method of manufacturing a semiconductor device using the impurity diffusion layer will be described.

A first embodiment of the method of manufacturing a semiconductor device according to the present invention includes the steps of applying the p-type impurity-diffusing composition of the present invention to a semiconductor substrate to form a p-type impurity-diffusing composition film; and diffusing p-type impurities from the p-type impurity-diffusing composition film to the semiconductor substrate to form a p-type impurity diffusion layer on the semiconductor substrate.

A second embodiment of the method of manufacturing a semiconductor device according to the present invention includes the steps of partially applying the p-type impurity-diffusing composition of the present invention to a semiconductor substrate to form a p-type impurity-diffusing composition film; and diffusing p-type impurities to the semiconductor substrate by simultaneously heating the p-type impurity-diffusing composition film in a p-type impurity-containing atmosphere, to form a high concentration p-type impurity diffusion layer region and a low concentration p-type impurity diffusion layer region on the semiconductor substrate. In the present invention, the term "high concentration p-type impurity diffusion layer region" refers to a region having a sheet resistance of 10 to 100 $\Omega/\square$. The term "low concentration p-type impurity diffusion layer region" refers to a region having a sheet resistance at least 10 $\Omega/\square$ higher than the high concentration p-type impurity diffusion layer region.

A third embodiment of the method of manufacturing a semiconductor device according to the present invention includes the steps of applying the p-type impurity-diffusing composition of the present invention to a semiconductor substrate to form a p-type impurity-diffusing composition film; applying an n-type impurity-diffusing composition onto the semiconductor substrate to form an n-type impurity-diffusing composition film; and forming a p-type impurity diffusion layer and an n-type impurity diffusion layer on the semiconductor substrate by simultaneously heating the p-type impurity-diffusing composition film and the n-type impurity-diffusing composition film.

A fourth embodiment of the method of manufacturing a semiconductor device according to the present invention includes the steps of applying the p-type impurity-diffusing composition of the present invention to one side of the semiconductor substrate to form a p-type impurity-diffusing composition film; and diffusing p-type impurities from the p-type impurity-diffusing composition to the semiconductor substrate to form a p-type impurity diffusion layer on the semiconductor substrate and then diffusing an n-type impurity diffusion component to the other side of the semiconductor substrate without removing the p-type impurity-diffusing composition film.

The method of forming an impurity diffusion layer which can be applied to these methods of manufacturing a semiconductor device will be described with reference to the drawings. These methods are merely exemplary and the method of forming an impurity diffusion layer which can be applied to the method of manufacturing a semiconductor device according to the present invention is not limited thereto.

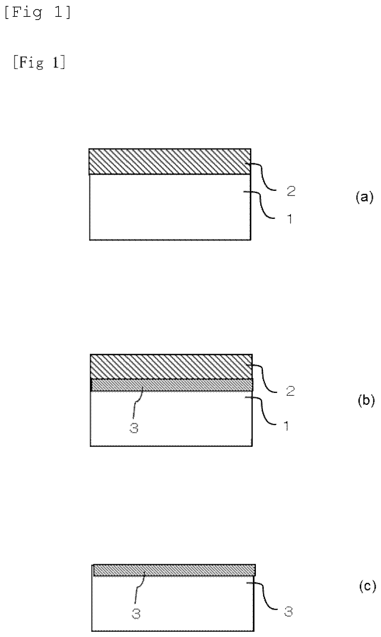

FIG. 1 shows a first example of the method of forming an impurity diffusion layer including the steps of applying the p-type impurity-diffusing composition of the present invention to a semiconductor substrate to form a p-type impurity-diffusing composition film; and diffusing p-type impurities from the p-type impurity-diffusing composition film to the semiconductor substrate to form a p-type impurity diffusion layer on the semiconductor substrate.

First, as shown in FIG. 1(a), a p-type impurity-diffusing composition film 2 is formed on a semiconductor substrate 1.

Examples of the semiconductor substrate 1 include n-type single-crystal silicon substrates having an impurity concentration of $10^{15}$ to $10^{16}$ atoms/cm$^3$, polycrystalline silicon substrates, and crystalline silicon substrates with other elements such as germanium and carbon added. P-type crystalline silicon substrates or semiconductor substrates made of materials other than silicon can also be used. The semiconductor substrate 1 preferably has a thickness of 50 to 300 $\mu$m and a shape of a roughly square of side 100 to 250 mm. To remove slice damage and naturally grown oxide, it is preferable to etch the surface using, for example, a hydrofluoric acid solution or an alkaline solution.

A barrier layer may be formed on a surface of the semiconductor substrate 1, the surface on which the p-type impurity-diffusing composition film 2 is not formed. As the barrier layer, a known barrier layer such as silicon oxide or silicon nitride, which is formed using a technique such as chemical vapor deposition (CVD) or spin on glass (SOG), can be used.

Examples of the method of applying the p-type impurity-diffusing composition include spin coating, screen printing, ink jet printing, slit coating, spray coating, relief printing, and intaglio printing. Of these, the p-type impurity-diffusing composition of the present invention can be preferably applied by screen printing.

After a coating film is formed by such a method, the p-type impurity-diffusing composition film 2 is preferably dried, for example, on a hot plate or in an oven at a temperature range of 50°C to 200°C for 30 seconds to 30 minutes. The thickness of the dried p-type impurity-diffusing composition film 2 is preferably at least 100 nm in terms of allowing p-type impurities to become easily diffused, and preferably 3 $\mu$m or less in terms of hardly generating residues after etching.

Next, as shown in FIG. 1(b), p-type impurities are diffused to the semiconductor substrate 1 to form a p-type impurity diffusion layer 3. The p-type impurities can be diffused by any known thermal diffusion method, and, for example, methods such as electrical heating, infrared heating, laser heating, and microwave heating can be used.

The time and temperature of thermal diffusion can be appropriately set so as to provide the desired diffusion properties such as impurity diffusion concentration and diffusion depth. For example, a p-type impurity diffusion layer having a surface impurity concentration of $10^{19}$ to $10^{21}$ atoms/cm$^3$ can be formed by thermal diffusion at 800°C to 1200°C for 1 to 120 minutes.

The diffusion atmosphere is not critical. The diffusion may be carried out in the air, or the oxygen content in the atmosphere may be appropriately controlled using an inert gas such as nitrogen or argon. From the viewpoint of shortening of diffusion time, the oxygen content in the atmosphere is preferably controlled to be 3% by volume or less. In order to thermally decompose at least a part of organic substances in the p-type impurity-diffusing composition film 2, firing may be performed at a temperature in the range of 200°C to 800°C for 1 to 120 minutes before the diffusion as required.

Next, as shown in FIG. 1(c), the p-type impurity-diffusing composition film 2 formed on the surface of the semiconductor substrate 1 is removed by a known etching process. The material used for etching may be any material, and, for example, a material is preferred which contains at least one of hydrogen fluoride, ammonium, phosphoric acid, sulfuric acid, and nitric acid as an etching component and other components such as water and organic solvent. Through the above process, a p-type impurity diffusion layer can be formed on a semiconductor substrate.

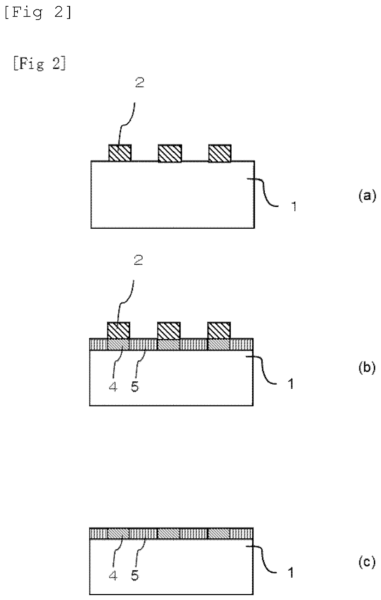

FIG. 2 shows a second example of the method of forming an impurity diffusion layer including the steps of partially applying the p-type impurity-diffusing composition to a semiconductor substrate to form a p-type impurity-diffusing composition film; and diffusing p-type impurities to the semiconductor substrate by simultaneously heating the p-type impurity-diffusing composition film in a p-type impurity-containing atmosphere, to form a high concentration p-type impurity diffusion layer region and a low concentration p-type impurity diffusion layer region on the semiconductor substrate.

First, as shown in FIG. 2(a), the p-type impurity-diffusing composition film 2 is partially formed on the semiconductor substrate 1.

Examples of the semiconductor substrate 1 include n-type single-crystal silicon substrates having an impurity concentration of $10^{15}$ to $10^{16}$ atoms/cm$^3$, polycrystalline silicon substrates, and crystalline silicon substrates with other elements such as germanium and carbon added. P-type crystalline silicon substrates or semiconductor substrates made of materials other than silicon can also be used. The semiconductor substrate 1 preferably has a thickness of 50 to 300 $\mu$m and a shape of a roughly square of side 100 to 250 mm. To remove slice damage and naturally grown oxide, it is preferable to etch the surface using, for example, a hydrofluoric acid solution or an alkaline solution.

A barrier layer may be formed on a surface of the semiconductor substrate 1, the surface on which the p-type impurity-diffusing composition film 2 is not formed. As the barrier layer, a known barrier layer such as silicon oxide or silicon nitride, which is formed using a technique such as chemical vapor deposition (CVD) or spin on glass (SOG), can be used.

Examples of the method of applying the p-type impurity-diffusing composition include screen printing, ink jet printing, slit coating, spray coating, relief printing, and intaglio printing. Of these, the p-type impurity-diffusing composition of the present invention can be preferably applied by screen printing.

After a coating film is formed by such a method, the p-type impurity-diffusing composition film 2 is preferably dried, for example, on a hot plate or in an oven at a temperature range of 50°C to 200°C for 30 seconds to 30 minutes. The thickness of the dried p-type impurity-diffusing composition film 2 is preferably at least 100 nm in terms of allowing p-type impurities to become easily diffused, and preferably 3 $\mu$m or less in terms of hardly generating residues after etching.

Next, as shown in FIG. 2(b), the p-type impurities are diffused to the semiconductor substrate 1 by simultaneously heating the p-type impurity-diffusing composition film 2 in a p-type impurity-containing atmosphere, to form a high concentration p-type impurity diffusion layer region 4 and a low concentration p-type impurity diffusion layer region 5 on the semiconductor substrate 1.

The p-type impurities can be diffused by any known thermal diffusion method, and, for example, methods such as electrical heating, infrared heating, laser heating, and microwave heating can be used.

The time and temperature of thermal diffusion can be appropriately set so as to provide the desired diffusion properties such as impurity diffusion concentration and diffusion depth. For example, a p-type impurity diffusion layer having a surface impurity concentration of $10^{19}$ to $10^{21}$ atoms/cm$^3$ can be formed by thermal diffusion at 800°C to 1200°C for 1 to 120 minutes.

The diffusion is carried out under the p-type impurity-containing atmosphere, and a p-type impurity-containing gas such as BBr$_3$ and BCl$_3$ is used. For example, BBr$_3$ gas can be obtained by bubbling N$_2$ gas or nitrogen/oxygen mixing gas in a BBr$_3$ solution or by heating the BBr$_3$ solution.

The gas atmosphere is not particularly limited, and is preferably formed of a mixing gas such as nitrogen, oxygen, argon, helium, xenon, neon, and krypton; more preferably a mixing gas of nitrogen and oxygen; and even more preferably a mixing gas of nitrogen and oxygen in which the content of oxygen is 5% by volume or less.

In order to thermally decompose at least a part of organic substances in the p-type impurity-diffusing composition film 2, firing may be performed at a temperature in the range of 200°C to 800°C for 1 to 120 minutes before the diffusion as required.

In FIG. 2(b), the p-type impurity diffusion layer formed of a p-type impurity-diffusing composition is a high concentration diffusion layer region 4, and the p-type impurity diffusion layer formed of a p-type impurity-containing atmosphere is the low concentration p-type impurity diffusion layer region 5. However, the p-type impurity diffusion layer formed of a p-type impurity-diffusing composition may be a low concentration diffusion layer region 5, and the p-type impurity diffusion layer formed of a p-type impurity-containing atmosphere may be the high concentration p-type impurity diffusion layer region 4. The p-type impurity concentration in the p-type impurity diffusion layer can be appropriately adjusted by the concentration of p-type impurities in the p-type impurity-diffusing composition, the content of the p-type impurity gas in the p-type impurity-containing atmosphere, diffusion temperature, diffusion time or the like.

Next, as shown in FIG. 2(c), the p-type impurity-diffusing composition film 2 formed on the surface of the semiconductor substrate 1 is removed by a known etching process. The material used for etching may be any material, and, for example, a material is preferred which contains at least one of hydrogen fluoride, ammonium, phosphoric acid, sulfuric acid, and nitric acid as an etching component and other components such as water and organic solvent. Through the above process, a high concentration p-type impurity diffusion layer region and a low concentration p-type impurity diffusion layer region can be formed on a semiconductor substrate.

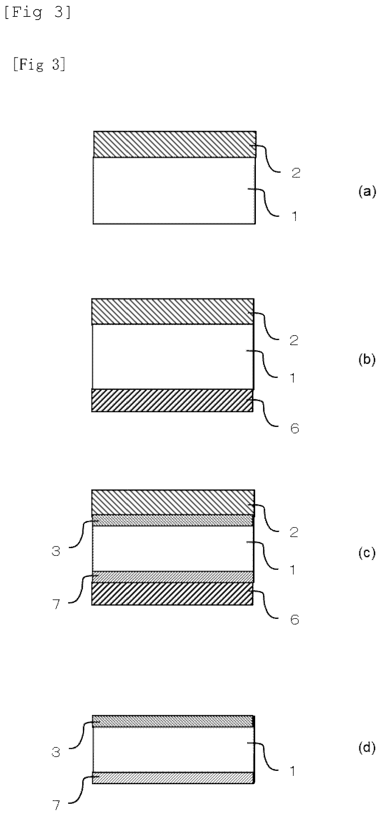

FIG. 3 shows a third example of the method of forming an impurity diffusion layer including the steps of applying the p-type impurity-diffusing composition to a semiconductor substrate to form a p-type impurity-diffusing composition film; applying an n-type impurity-diffusing composition onto the semiconductor substrate to form an n-type impurity-diffusing composition film; and forming a p-type impurity diffusion layer and an n-type impurity diffusion layer on the semiconductor substrate by simultaneously heating the p-type impurity-diffusing composition film and the n-type impurity-diffusing composition film.

First, as shown in FIG. 3(a), a p-type impurity-diffusing composition of the present invention is applied to one side of the semiconductor substrate 1 to form a p-type impurity-diffusing composition film 2.

Examples of the semiconductor substrate 1 include n-type single-crystal silicon substrates having an impurity concentration of $10^{15}$ to $10^{16}$ atoms/cm$^3$, polycrystalline silicon substrates, and crystalline silicon substrates with other elements such as germanium and carbon added. P-type crystalline silicon substrates or semiconductor substrates made of materials other than silicon can also be used. The semiconductor substrate 1 preferably has a thickness of 50 to 300 $\mu$m and a shape of a roughly square of side 100 to 250 mm. To remove slice damage and naturally grown oxide, it is preferable to etch the surface using, for example, a hydrofluoric acid solution or an alkaline solution.

Examples of the method of forming the p-type impurity-diffusing composition film 2 include screen printing, ink jet printing, slit coating, spray coating, relief printing, and intaglio printing. Of these, the p-type impurity-diffusing composition of the present invention can be preferably applied by screen printing.

After a coating film is formed by such a method, the p-type impurity-diffusing composition film 2 is preferably dried, for example, on a hot plate or in an oven at a temperature range of 50°C to 200°C for 30 seconds to 30 minutes. The thickness of the dried p-type impurity-diffusing composition film 2 is preferably at least 100 nm in terms of allowing p-type impurities to be easily diffused, and preferably 3 $\mu$m or less in terms of hardly generating residues after etching. In order to thermally decompose at least a part of organic substances in the p-type impurity-diffusing composition film 2, firing may be performed at a temperature in the range of 200°C to 800°C for 1 to 120 minutes before the diffusion as required.

Next, as shown in FIG. 3(b), an n-type impurity-diffusing composition film 6 of the present invention is formed on the other side of the semiconductor substrate 1.

To form the n-type impurity-diffusing composition, for example, a known material disclosed in JP 2011-71489 A or JP 2012-114298 A can be used.

Examples of the method of forming the n-type impurity-diffusing composition film 6 include screen printing, ink jet printing, slit coating, spray coating, relief printing, and intaglio printing.

After a coating film is formed by such a method, the p-type impurity-diffusing composition film 2 is preferably dried, for example, on a hot plate or in an oven at a temperature range of 50°C to 200°C for 30 seconds to 30 minutes.

The dried n-type impurity-diffusing composition film 6 preferably has a thickness in the range of 100 nm or more and 5 $\mu$m or less. The thickness of the n-type impurity-diffusing composition film 6 in the above range is preferable because residues after etching hardly generate. In order to thermally decompose at least a part of organic substances in the n-type impurity-diffusing composition film 6, firing may be performed at a temperature in the range of 200°C to 800°C for 1 to 120 minutes before the diffusion as required.

Next, as shown in FIG. 3(c), impurities in the p-type impurity diffusion composition film 2 and the n-type impurity-diffusing composition film 6 are simultaneously diffused into the semiconductor substrate 1 to form the p-type impurity diffusion layer 3 and an n-type impurity diffusion layer 7.

The impurities can be diffused by any known thermal diffusion method, and, for example, methods such as electrical heating, infrared heating, laser heating, and microwave heating can be used.

The time and temperature of thermal diffusion can be appropriately set so as to provide the desired diffusion properties such as impurity diffusion concentration and diffusion depth. For example, a p-type and an n-type impurity diffusion layers having a surface impurity concentration of $10^{19}$ to $10^{21}$ atoms/cm$^3$ can be formed by thermal diffusion at 800°C to 1200°C for 1 to 120 minutes.

The diffusion atmosphere is not critical. The diffusion may be carried out in the air, or the oxygen content in the atmosphere may be appropriately controlled using an inert gas such as nitrogen or argon. From the viewpoint of shortening of diffusion time, the oxygen content in the atmosphere is preferably controlled to be 3% by volume or less.

Next, as shown in FIG. 3(d), the p-type impurity-diffusing composition film 2 and the n-type impurity-diffusing composition film 6 formed on the surface of the semiconductor substrate 1 are removed by a known etching process. Through the above process, n-type and p-type impurity diffusion layers can be formed on a semiconductor substrate. By employing such a process, simplified steps compared to those in conventional methods can be achieved.

In the above description, an example is given in which an n-type impurity-diffusing composition is applied and then a p-type impurity-diffusing composition is applied, but it is also possible to apply an n-type impurity-diffusing composition and then apply a p-type impurity-diffusing composition.

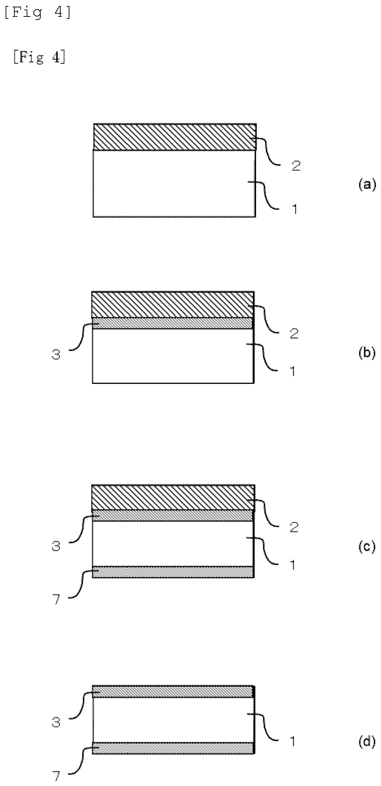

FIG. 4 shows a fourth example of the method of forming an impurity diffusion layer including the steps of applying the p-type impurity-diffusing composition of the present invention to one side of the semiconductor substrate to form a p-type impurity-diffusing composition film; and diffusing p-type impurities from the p-type impurity-diffusing composition to the semiconductor substrate to form a p-type impurity diffusion layer on the semiconductor substrate and then diffusing an n-type impurity diffusion component to the other side of the semiconductor substrate without removing the p-type impurity-diffusing composition film.

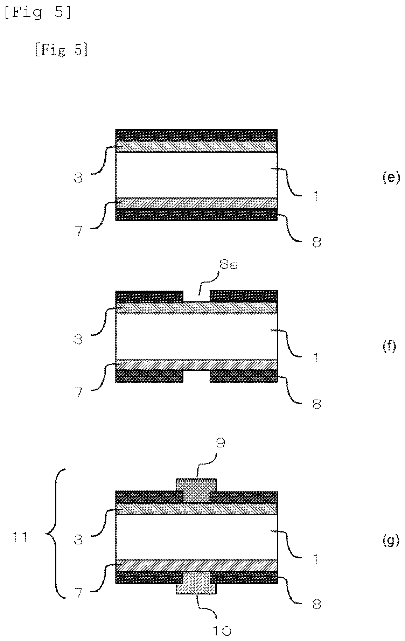

FIG. 5 shows an example of the method of manufacturing a double side power generation type solar cell using a semiconductor device obtained by applying the method of forming the impurity diffusion layer of FIG. 4.

First, as shown in FIG. 4(a), the p-type impurity-diffusing composition of the present invention is applied to one side of the semiconductor substrate 1 to form the p-type impurity-diffusing composition film 2.

Examples of the semiconductor substrate 1 include n-type single-crystal silicon substrates having an impurity concentration of $10^{15}$ to $10^{16}$ atoms/cm$^3$, polycrystalline silicon substrates, and crystalline silicon substrates with other elements such as germanium and carbon added. P-type crystalline silicon substrates or semiconductor substrates made of materials other than silicon can also be used. The semiconductor substrate 1 preferably has a thickness of 50 to 300 $\mu$m and a shape of a roughly square of side 100 to 250 mm. To remove slice damage and naturally grown oxide, it is preferable to etch the surface using, for example, a hydrofluoric acid solution or an alkaline solution.

Examples of the method of forming the p-type impurity-diffusing composition film 2 include screen printing, ink jet printing, slit coating, spray coating, relief printing, and intaglio printing. Of these, the p-type impurity-diffusing composition of the present invention can be preferably applied by screen printing.

After a coating film is formed by such a method, the p-type impurity-diffusing composition film 2 is preferably dried, for example, on a hot plate or in an oven at a temperature range of 50°C to 200°C for 30 seconds to 30 minutes. The thickness of the dried p-type impurity-diffusing composition film 2 is preferably at least 100 nm in terms of diffusibility of p-type impurities, and preferably 3 $\mu$m or less in terms of hardly generating residue after etching. In order to thermally decompose at least a part of organic substances in the p-type impurity-diffusing composition film 2, firing may be performed at a temperature in the range of 200°C to 800°C for 1 to 120 minutes before the diffusion as required.

Next, as shown in FIG. 4(b), p-type impurities are diffused to the semiconductor substrate 1 to form the p-type impurity diffusion layer 3. The p-type impurities can be diffused by any known thermal diffusion method, and, for example, methods such as electrical heating, infrared heating, laser heating, and microwave heating can be used.

The time and temperature of thermal diffusion can be appropriately set so as to provide the desired diffusion properties such as impurity diffusion concentration and diffusion depth. For example, a p-type impurity diffusion layer having a surface impurity concentration of $10^{19}$ to $10^{21}$ atoms/cm$^3$ can be formed by thermal diffusion at 800°C to 1200°C for 1 to 120 minutes.

The diffusion atmosphere is not critical. The diffusion may be carried out in the air, or the oxygen content in the atmosphere may be appropriately controlled using an inert gas such as nitrogen or argon. From the viewpoint of shortening of diffusion time, the oxygen content in the atmosphere is preferably controlled to be 3% by volume or less. In order to thermally decompose at least a part of organic substances in the p-type impurity-diffusing composition film 2, firing may be performed at a temperature in the range of 200°C to 800°C for 1 to 120 minutes before the diffusion as required.

Next, as shown in FIG. 4(c), the p-type impurity-diffusing composition film 2 remains on the top of the p-type impurity diffusion layer 3. Such layer is used as a mask against the n-type impurities, and the n-type diffusion layer 7 is formed on the other side of the semiconductor substrate.

As the method of forming an n-type diffusion layer, a coating diffusion method using an n-type impurity-diffusing composition or a gas diffusion method using gas containing n-type impurities can be used. As for the coating diffusion method using an n-type impurity-diffusing composition, an n-type diffusion layer can be formed by applying and diffusing the n-type impurity-diffusing composition by the above-described method.

In the case of the gas diffusion method using gas containing n-type impurities, a semiconductor substrate is heated under flowing gas containing n-type impurities to form the n-type impurity diffusion layer 7.

Examples of the gas containing n-type impurities include $POCl_3$ gas. For example, $POCl_3$ gas can be obtained by bubbling $N_2$ gas or nitrogen/oxygen mixing gas in a $POCl_3$ solution or by heating the $POCl_3$ solution.

The heating temperature is preferably in the range of 750°C to 1050°C, and more preferably 800°C to 1000°C. The heating time is preferably in the range of 1 to 120 minutes.

The gas atmosphere is not particularly limited, and is preferably formed of a mixing gas such as nitrogen, oxygen, argon, helium, xenon, neon, and krypton; more preferably a mixing gas of nitrogen and oxygen; and even more preferably a mixing gas of nitrogen and oxygen in which the content of oxygen is 5% by volume or less.

Next, as shown in FIG. 4(d), the p-type impurity-diffusing composition film 2 formed on the surface of the semiconductor substrate 1 is removed by a known etching process. Through the above process, n-type and p-type impurity diffusion layers can be formed on a semiconductor substrate. By employing such a process, simplified steps compared to those in conventional methods can be achieved.

Subsequently, referring to FIG. 5, an example of the method of manufacturing a double side power generation type solar cell using a semiconductor device obtained by applying the method of forming the impurity diffusion layer of FIG. 4 will be described.

First, as shown in FIG. 5(e), a barrier layer 8 is formed each on a light receiving face and a back surface of the semiconductor substrate 1.

A known material can be used in these layers. These layers may be a single layer or multiple layers. Examples of the layer include a laminated layer of thermal oxide layer, aluminum oxide layer, SiNx layer, or amorphous silicon layer. These layers can be formed by a vapor deposition method such as plasma CVD and ALD(atomic layer deposition), or a coating method.

Next, as shown in FIG. 5(f), the barrier layer 8 is patterned, for example, by etching to form a barrier layer opening 8a.

Furthermore, as shown in FIG. 5(g), using a technique such as stripe coating or screen printing, electrode paste is applied in a pattern to regions each including the barrier layer opening 8a and fired to form a p-type contact electrode 9 and an n-type contact electrode 10. As the electrode paste, for example, silver paste or the like that is commonly used in the art can be used. As a result of this, a double side power generation type solar cell 11 is obtained.

The present invention is not limited to the embodiments described above. Various modifications such as design changes can be made based on the knowledge of those skilled in the art, and embodiments in which such a modification is made are also within the scope of the present invention.

The p-type impurity-diffusing composition of the present invention can be used for photovoltaic devices, such as solar cells, as well as semiconductor devices obtained by patterning an impurity diffusion region on a semiconductor surface, such as transistor arrays, diode arrays, photodiode arrays, and transducers.

Examples

The present invention will now be described in more detail with reference to examples, but these examples are not intended to limit the present invention. The abbreviations used to denote compounds used in examples are shown below.

$B_2O_3$:     Boron oxide
PVA:     Polyvinyl alcohol
PVB:     Polyvinyl butyral
γ-BL:     γ-butyrolactone
δ-VL:     δ-valerolactone

PGME: Propylene glycol monomethyl ether
1-BuOH: 1-butanol
PGMEA: Propylene glycol monomethyl ether acetate
EG: Ethylene glycol
PEO: Polyethylene oxide
HEC: Hydroxyethyl cellulose

(1) Viscosity and Storage Stability

For impurity-diffusing compositions having a viscosity of less than 1,000 mPa·s, the viscosity at a solution temperature of 25°C and a rotation speed of 20 rpm was measured using a rotational viscometer TVE-25L (E-type digital viscometer) manufactured by Toki Sangyo Co., Ltd. For impurity-diffusing compositions having a viscosity of 1,000 mPa·s or more, the viscosity at a solution temperature of 25°C and a rotation speed of 20 rpm was measured using RVDV-11+P (B-type digital viscometer) manufactured by Brookfield. To evaluate storage stability, the viscosity of the p-type impurity-diffusing composition immediately after preparation and the viscosity thereof stored at 25°C for 7 days after the preparation were measured. The viscosity of which the increase ratio was 5% or less was evaluated to be excellent (A), that of more than 5% and 10% or less to be good (B), and that of more than 10% to be bad (C). The increase ratio of the viscosity was determined by the following equation:

$$\text{Increase ratio of viscosity (\%)} = \text{(viscosity after 7-day storage} - \text{viscosity immediately after preparation)} / \text{(viscosity immediately after preparation)} \times 100$$

(2) Measuring Sheet Resistance

An n-type silicon wafer (manufactured by Ferrotec Silicon Corporation, surface resistivity: 410 $\Omega/\square$) cut to 3 cm × 3 cm was immersed in a 1% by mass aqueous hydrofluoric acid solution for 1 minute, washed with water, blown with air, and then pre-baked using a hot plate at 140°C for 5 minutes.
A p-type impurity-diffusing composition to be measured was applied to the silicon wafer by known spin coating such that the thickness after pre-baking would be 500 nm. In the case of screen printing, it was applied to the silicon wafer such that the thickness after pre-baking would be 1000 nm. After the application, the silicon wafer was pre-baked at 140°C for 5 minutes.
The silicon wafer was then placed in an electric furnace and held at 900°C for 30 minutes in an atmosphere of nitrogen and oxygen of 99:1 (volume ratio) to thermally diffuse impurities. After the thermal diffusion, the silicon wafer was immersed in a 5% by mass aqueous hydrofluoric acid solution at 23°C for 1 minute to remove the cured diffusion agent. For the silicon wafer after the removal, the type, whether p or n, was determined using a p/n checker, and the surface resistance was measured at three points using a four point probe measurement apparatus RT-70V (manufactured by NAPSON CORPORATION) and the average value was determined as the sheet resistance. The sheet resistance is an indicator of impurity diffusibility, and smaller resistance values indicate larger amounts of impurity diffusion.

(3) Diffusion Uniformity

As for the silicon wafer after the diffusion used to measure sheet resistance, a secondary ion mass spectrometer IMS7f (manufactured by Cameca) was used to determine a surface concentration distribution of impurities. The surface concentration was read at 10 points each at an interval of 100 $\mu$m from the obtained surface concentration distribution, and a ratio of the average concentration and the standard deviation, "standard deviation/average", was then calculated. A "standard deviation/average" of 0.5 or less was evaluated to be excellent (A), that of more than 0.5 and 1.0 or less to be good (B), and that of more than 1.0 to be bad (C).

(4) Screen Printing Property

A p-type impurity-diffusing composition was formed into a stripe pattern by screen printing, and the width accuracy of the stripe was observed.
For a substrate, a semiconductor substrate of side 156 mm composed of n-type single-crystal silicon was provided and alkaline etched on both surfaces to remove slice damage and naturally grown oxide. As a result of this, a myriad of typical irregularities about 40 to 100 $\mu$m in width and 3 to 4 $\mu$m in depth were formed on both surfaces of the semiconductor substrate, which was used as a substrate to be coated.

Using a screen printer (model TM-750 manufactured by Micro-tec Co., Ltd.), a screen mask in which 175 openings having 200 $\mu$m in width and 13.5 cm in length were formed at a pitch of 600 $\mu$m (manufactured by SUS, 400 meshes, wire diameter: 23 $\mu$m) was used to form a stripe pattern.

After the screen printing of the p-type impurity-diffusing composition, the substrate was heated in air at 140°C for 5 minutes, further at 230°C for 30 minutes, to form a 600-$\mu$m pitch pattern about 1.5 $\mu$m in thickness, about 210 $\mu$m in width, and 13.5 cm in length.

For randomly-selected one line, the line width was measured at 10 points at regular intervals. A coating width standard deviation of 12.5 $\mu$m or less was evaluated to be excellent (A), that of more than 12.5 $\mu$m and 15 $\mu$m or less to be good (B), and that of more than 15 $\mu$m and 17.5 $\mu$m or less to be bad (C).

(5) Evaluation of Thixotropic Index (TI Value)

The viscosities at a solution temperature of 25°C and rotation speeds of 2 rpm and 20 rpm were measured using RVDV-11+P (B-type digital viscometer) manufactured by Brookfield. A TI value is a ratio of the viscosity at a rotation speed of 2 rpm to the viscosity at a rotation speed of 20 rpm.

Example 1

Into a 500-mL three-necked flask, 20.8 g of PVA (manufactured by Wako Pure Chemical Industries, Ltd., polymerization degree of 500 and saponification degree of 88 mol%) and 144 g of water were loaded, and then heated to 80°C with stirring. After one-hour stirring, 231.6 g of $\gamma$-BL (manufactured by Mitsubishi Chemical Corporation) and 3.6 g of $B_2O_3$ (manufactured by Wako Pure Chemical Industries, Ltd.) were added and stirred at 80°C for 1 hour. After the stirred mixture was cooled to 40°C, 0.12 g of fluorochemical surfactant MEGAFACE F477 (manufactured by Dainippon Ink And Chemicals, Incorporated) was added and stirred for 30 minutes. Components (A) to (C) in the p-type impurity-diffusing composition, contents of components in the hydroxyl group-containing polymer (B), and contents of components in the organic solvent (C) are shown in Table 1.

The viscosity of the above-obtained p-type impurity-diffusing composition immediately after preparation, the viscosity thereof stored at 25°C for 7 days after the preparation, the increase ratio of the viscosity, and the storage stability are shown in Table 2. The storage stability was evaluated to be excellent. The p-type impurity-diffusing composition stored at 25°C for 7 days was applied to the silicon wafer by spin coating and diffused to measure sheet resistance and diffusion uniformity. As shown in Table 2, the diffusion uniformity was evaluated to be excellent.

Example 2

An impurity-diffusing composition was obtained in the same manner as in Example 1 except that the amounts of $\gamma$-BL and PGME were 162.2 g and 69.4 g, respectively. Components (A) to (C) in the p-type impurity-diffusing composition, contents of components in the hydroxyl group-containing polymer (B), and contents of components in the organic solvent (C) are shown in Table 1.

The viscosity of the above-obtained p-type impurity-diffusing composition immediately after preparation, the viscosity thereof stored at 25°C for 7 days after the preparation, the increase ratio of the viscosity, and the storage stability are shown in Table 2. The storage stability was evaluated to be excellent. Using the p-type impurity-diffusing composition stored at 25°C for 7 days, the sheet resistance and diffusion uniformity were measured in the same manner as in Example 1. As shown in Table 2, the diffusion uniformity was evaluated to be excellent.

Example 3

An impurity-diffusing composition was obtained in the same manner as in Example 1 except that the amounts of $\gamma$-BL and PGME were 139.0 g and 92.6 g, respectively. Components (A) to (C) in the p-type impurity-diffusing composition, contents of components in the hydroxyl group-containing polymer (B), and contents of components in the organic solvent (C) are shown in Table 1.

The viscosity of the above-obtained p-type impurity-diffusing composition immediately after preparation, the viscosity thereof stored at 25°C for 7 days after the preparation, the increase ratio of the viscosity, and the storage stability are shown in Table 2. The storage stability was evaluated to be good. Using the p-type impurity-diffusing composition stored at 25°C for 7 days, the sheet resistance and diffusion uniformity were measured in the same manner as in Example 1. As shown in Table 2, the diffusion uniformity was evaluated to be good.

Example 4

An impurity-diffusing composition was obtained in the same manner as in Example 1 except that the amounts of $\gamma$-BL and PGME were 92.7 g and 138.9 g, respectively. Components (A) to (C) in the p-type impurity-diffusing composition, contents of components in the hydroxyl group-containing polymer (B), and contents of components in the organic solvent (C) are shown in Table 1.

The viscosity of the above-obtained p-type impurity-diffusing composition immediately after preparation, the viscosity thereof stored at 25°C for 7 days after the preparation, the increase ratio of the viscosity, and the storage stability are shown in Table 2. The storage stability was evaluated to be good. Using the p-type impurity-diffusing composition stored at 25°C for 7 days, the sheet resistance and diffusion uniformity were measured in the same manner as in Example 1. As shown in Table 2, the diffusion uniformity was evaluated to be good.

Example 5

An impurity-diffusing composition was obtained in the same manner as in Example 2 except that 1-BuOH was used instead of PGME. Components (A) to (C) in the p-type impurity-diffusing composition, contents of components in the hydroxyl group-containing polymer (B), and contents of components in the organic solvent (C) are shown in Table 1.

The viscosity of the above-obtained p-type impurity-diffusing composition immediately after preparation and the viscosity thereof stored at 25°C for 7 days after the preparation are shown in Table 2. The storage stability was evaluated to be excellent. Using the p-type impurity-diffusing composition stored at 25°C for 7 days, the sheet resistance and diffusion uniformity were measured in the same manner as in Example 1. As shown in Table 2, the diffusion uniformity was evaluated to be excellent.

Example 6

An impurity-diffusing composition was obtained in the same manner as in Example 1 except that boric acid was used instead of $B_2O_3$. Components (A) to (C) in the p-type impurity-diffusing composition, contents of components in the hydroxyl group-containing polymer (B), and contents of components in the organic solvent (C) are shown in Table 1.

The viscosity of the above-obtained p-type impurity-diffusing composition immediately after preparation, the viscosity thereof stored at 25°C for 7 days after the preparation, the increase ratio of the viscosity, and the storage stability are shown in Table 2. The storage stability was evaluated to be excellent. Using the p-type impurity-diffusing composition stored at 25°C for 7 days, the sheet resistance and diffusion uniformity were measured in the same manner as in Example 1. As shown in Table 2, the diffusion uniformity was evaluated to be excellent.

Example 7

An impurity-diffusing composition was obtained in the same manner as in Example 1 except that PVB (acetalization degree of 72% by weight and molecular weight of 33000) was used instead of PVA. Components (A) to (C) in the p-type impurity-diffusing composition, contents of components in the hydroxyl group-containing polymer (B), and contents of components in the organic solvent (C) are shown in Table 1.

The viscosity of the above-obtained p-type impurity-diffusing composition immediately after preparation, the viscosity thereof stored at 25°C for 7 days after the preparation, the increase ratio of the viscosity, and the storage stability are shown in Table 2. The storage stability was evaluated to be good. Using the p-type impurity-diffusing composition stored at 25°C for 7 days, the sheet resistance and diffusion uniformity were measured in the same manner as in Example 1. As shown in Table 2, the diffusion uniformity was evaluated to be good.

Example 8

An impurity-diffusing composition was obtained in the same manner as in Example 1 except that $\delta$-VL was used instead of $\gamma$-BL. Components (A) to (C) in the p-type impurity-diffusing composition, contents of components in the hydroxyl group-containing polymer (B), and contents of components in the organic solvent (C) are shown in Table 1.

The viscosity of the above-obtained p-type impurity-diffusing composition immediately after preparation, the viscosity thereof stored at 25°C for 7 days after the preparation, the increase ratio of the viscosity, and the storage stability are shown in Table 2. The storage stability was evaluated to be good. Using the p-type impurity-diffusing composition stored at 25°C for 7 days, the sheet resistance and diffusion uniformity were measured in the same manner as in Example 1. As shown in Table 2, the diffusion uniformity was evaluated to be good.

Example 9

Into a 500-mL three-necked flask, 13.3 g of PVA (manufactured by Wako Pure Chemical Industries, Ltd., polymerization degree of 500, saponification degree of 88 mol%), 16.0 g of PEO (manufactured by Sumitomo Seika Chemicals Co., Ltd., product name "PEO-3") and 144 g of water were loaded, and then heated to 80°C with stirring. After one-hour stirring, 222.4 g of $\gamma$-BL (manufactured by Mitsubishi Chemical Corporation) and 2.3 g of $B_2O_3$ (manufactured by Wako Pure Chemical Industries, Ltd.) were added and stirred at 80°C for 1 hour. After the stirred mixture was cooled to 40°C, 0.12 g of fluorochemical surfactant MEGAFACE F477 (manufactured by Dainippon Ink And Chemicals, Incorporated) was added and stirred for 30 minutes. Components (A) to (C) in the p-type impurity-diffusing composition, contents of components in the hydroxyl group-containing polymer (B), and contents of components in the organic solvent (C) are shown in Table 1.

The viscosity of the above-obtained p-type impurity-diffusing composition immediately after preparation, the viscosity thereof stored at 25°C for 7 days after the preparation, the increase ratio of the viscosity, the storage stability, and TI value are shown in Table 2. The storage stability was evaluated to be excellent. When a screen printing test was conducted using the p-type impurity-diffusing composition stored at 25°C for 7 days, the screen printing property was evaluated to be excellent as shown in Table 2. Using the p-type impurity-diffusing composition stored at 25°C for 7 days, the sheet resistance and diffusion uniformity were measured in the same manner as in Example 1. As shown in Table 2, the diffusion uniformity was evaluated to be excellent.

Example 10

An impurity-diffusing composition was obtained in the same manner as in Example 9 except that the amounts of $\gamma$-BL and EG were 157.1 g and 67.3 g, respectively. Components (A) to (C) in the p-type impurity-diffusing composition, contents of components in the hydroxyl group-containing polymer (B), and contents of components in the organic solvent (C) are shown in Table 1.

The viscosity of the above-obtained p-type impurity-diffusing composition immediately after preparation, the viscosity thereof stored at 25°C for 7 days after the preparation, the increase ratio of the viscosity, the storage stability, and TI value are shown in Table 2. The storage stability was evaluated to be excellent. When a screen printing test was conducted using the p-type impurity-diffusing composition stored at 25°C for 7 days, the screen printing property was evaluated to be excellent as shown in Table 2. Using the p-type impurity-diffusing composition stored at 25°C for 7 days, the sheet resistance and diffusion uniformity were measured in the same manner as in Example 1. As shown in Table 2, the diffusion uniformity was evaluated to be excellent.

Example 11

An impurity-diffusing composition was obtained in the same manner as in Example 9 except that 7.0 g of PVA (manufactured by Wako Pure Chemical Industries, Ltd., polymerization degree of 500, saponification degree of 88 mol%) and 16.0 g of PEO (manufactured by Sumitomo Seika Chemicals Co., Ltd., product name "PEO-3") were used. Components (A) to (C) in the p-type impurity-diffusing composition, contents of components in the hydroxyl group-containing polymer (B), and contents of components in the organic solvent (C) are shown in Table 1.

The viscosity of the above-obtained p-type impurity-diffusing composition immediately after preparation, the viscosity thereof stored at 25°C for 7 days after the preparation, the increase ratio of the viscosity, the storage stability, and TI value are shown in Table 2. The storage stability was evaluated to be excellent. When a screen printing test was conducted using the p-type impurity-diffusing composition stored at 25°C for 7 days, the screen printing property was evaluated to be excellent as shown in Table 2. Using the p-type impurity-diffusing composition stored at 25°C for 7 days, the sheet resistance and diffusion uniformity were measured in the same manner as in Example 1. As shown in Table 2, the diffusion uniformity was evaluated to be excellent.

Example 12

An impurity-diffusing composition was obtained in the same manner as in Example 9 except that 4.0 g of PVA (manufactured by Wako Pure Chemical Industries, Ltd., polymerization degree of 500, saponification degree of 88 mol%) and 16.0 g of PEO (manufactured by Sumitomo Seika Chemicals Co., Ltd., product name "PEO-3") were used. Components (A) to (C) in the p-type impurity-diffusing composition, contents of components in the hydroxyl group-containing polymer (B), and contents of components in the organic solvent (C) are shown in Table 1.

The viscosity of the above-obtained p-type impurity-diffusing composition immediately after preparation, the viscosity thereof stored at 25°C for 7 days after the preparation, the increase ratio of the viscosity, the storage stability, and TI value are shown in Table 2. The storage stability was evaluated to be excellent. When a screen printing test was conducted using the p-type impurity-diffusing composition stored at 25°C for 7 days, the screen printing property was evaluated to be good as shown in Table 2. Using the p-type impurity-diffusing composition stored at 25°C for 7 days, the sheet resistance and diffusion uniformity were measured in the same manner as in Example 1. As shown in Table 2, the diffusion uniformity was evaluated to be good.

Example 13

An impurity-diffusing composition was obtained in the same manner as in Example 9 except that 24.0 g of PVA (manufactured by Wako Pure Chemical Industries, Ltd., polymerization degree of 500, saponification degree of 88 mol%) and 16.0 g of PEO (manufactured by Sumitomo Seika Chemicals Co., Ltd., product name "PEO-3") were used. Components (A) to (C) in the p-type impurity-diffusing composition, contents of components in the hydroxyl group-containing polymer (B), and contents of components in the organic solvent (C) are shown in Table 1.

The viscosity of the above-obtained p-type impurity-diffusing composition immediately after preparation, the viscosity thereof stored at 25°C for 7 days after the preparation, the increase ratio of the viscosity, the storage stability, and TI value are shown in Table 2. The storage stability was evaluated to be excellent. When a screen printing test was conducted using the p-type impurity-diffusing composition stored at 25°C for 7 days, the screen printing property was evaluated to be excellent as shown in Table 2. Using the p-type impurity-diffusing composition stored at 25°C for 7 days, the sheet resistance and diffusion uniformity were measured in the same manner as in Example 1. As shown in Table 2, the diffusion uniformity was evaluated to be excellent.

Example 14

An impurity-diffusing composition was obtained in the same manner as in Example 9 except that 37.3 g of PVA (manufactured by Wako Pure Chemical Industries, Ltd., polymerization degree of 500, saponification degree of 88 mol%) and 16.0 g of PEO (manufactured by Sumitomo Seika Chemicals Co. , Ltd., product name "PEO-3") were used. Components (A) to (C) in the p-type impurity-diffusing composition, contents of components in the hydroxyl group-containing polymer (B), and contents of components in the organic solvent (C) are shown in Table 1.

The viscosity of the above-obtained p-type impurity-diffusing composition immediately after preparation, the viscosity thereof stored at 25°C for 7 days after the preparation, the increase ratio of the viscosity, the storage stability, and TI value are shown in Table 2. The storage stability was evaluated to be good. When a screen printing test was conducted using the p-type impurity-diffusing composition stored at 25°C for 7 days, the screen printing property was evaluated to be bad as shown in Table 2. Using the p-type impurity-diffusing composition stored at 25°C for 7 days, the sheet resistance and diffusion uniformity were measured in the same manner as in Example 1. As shown in Table 2, the diffusion uniformity was evaluated to be good.

Example 15

An impurity-diffusing composition was obtained in the same manner as in Example 9 except that 7.2 g of PVA (manufactured by Wako Pure Chemical Industries, Ltd., polymerization degree of 500, saponification degree of 88 mol%) and 8.0 g of HEC (manufactured by Sumitomo Seika Chemicals Co., Ltd., product name "HEC CF-V") were used. Components (A) to (C) in the p-type impurity-diffusing composition, contents of components in the hydroxyl group-containing polymer (B), and contents of components in the organic solvent (C) are shown in Table 1.

The viscosity of the above-obtained p-type impurity-diffusing composition immediately after preparation, the viscosity thereof stored at 25°C for 7 days after the preparation, the increase ratio of the viscosity, the storage stability, and TI value are shown in Table 2. The storage stability was evaluated to be excellent. When a screen printing test was conducted using the p-type impurity-diffusing composition stored at 25°C for 7 days, the screen printing property was evaluated to be bad as shown in Table 2. Using the p-type impurity-diffusing composition stored at 25°C for 7 days, the sheet resistance and diffusion uniformity were measured in the same manner as in Example 1. As shown in Table 2, the diffusion uniformity was evaluated to be good.

Example 16

Into a 500-mL three-necked flask, 20.0 g of PVA (manufactured by Wako Pure Chemical Industries, Ltd., polymerization degree of 1500, saponification degree of 88 mol%) and 144 g of water were loaded, and then heated to 80°C with stirring. After one-hour stirring, 233.6 g of $\gamma$-BL (manufactured by Mitsubishi Chemical Corporation) and 2.4 g of $B_2O_3$ (manufactured by Wako Pure Chemical Industries, Ltd.) were added and stirred at 80°C for 1 hour. After the stirred mixture was cooled to 40°C, 0.12 g of fluorochemical surfactant MEGAFACE F477 (manufactured by Dainippon Ink And Chemicals, Incorporated) was added and stirred for 30 minutes. Components (A) to (C) in the p-type impurity-diffusing composition, contents of components in the hydroxyl group-containing polymer (B), and contents of components in the organic solvent (C) are shown in Table 1.

The viscosity of the above-obtained p-type impurity-diffusing composition immediately after preparation, the viscosity thereof stored at 25°C for 7 days after the preparation, the increase ratio of the viscosity, the storage stability, and TI value are shown in Table 2. The storage stability was evaluated to be good. When a screen printing test was conducted using the p-type impurity-diffusing composition stored at 25°C for 7 days, the screen printing property was evaluated to be bad as shown in Table 2. Using the p-type impurity-diffusing composition stored at 25°C for 7 days, the sheet resistance and diffusion uniformity were measured in the same manner as in Example 1. As shown in Table 2, the diffusion uniformity was evaluated to be good.

Comparative Example 1

An impurity-diffusing composition was obtained in the same manner as in Example 1 except that PGME was used instead of γ-BL. Components (A) to (C) in the p-type impurity-diffusing composition, contents of components in the hydroxyl group-containing polymer (B), and contents of components in the organic solvent (C) are shown in Table 1.

The viscosity of the above-obtained p-type impurity-diffusing composition immediately after preparation, the viscosity thereof stored at 25°C for 7 days after the preparation, the increase ratio of the viscosity, and the storage stability are shown in Table 2. The storage stability was evaluated to be bad. Using the p-type impurity-diffusing composition stored at 25°C for 7 days, the sheet resistance and diffusion uniformity were measured in the same manner as in Example 1. As shown in Table 2, the diffusion uniformity was evaluated to be bad.

Comparative Example 2

A p-type impurity-diffusing composition was obtained in the same manner as in Example 1 except that 1-BuOH was used instead of γ-BL. Components (A) to (C) in the p-type impurity-diffusing composition, contents of components in the hydroxyl group-containing polymer (B), and contents of components in the organic solvent (C) are shown in Table 1.

The storage stability of the p-type impurity-diffusing composition stored at 25°C for 7 days was bad, and when the diffusion uniformity thereof was measured, the diffusion was uneven as shown in Table 2.

Comparative Example 3

A p-type impurity-diffusing composition was prepared in the same manner as in Example 1 except that PGMEA was used instead of γ-BL. Components (A) to (C) in the p-type impurity-diffusing composition, contents of components in the hydroxyl group-containing polymer (B), and contents of components in the organic solvent (C) are shown in Table 1.

The p-type impurity-diffusing composition obtained above became cloudy, failing to obtain a uniform coating solution.

Comparative Example 4

A p-type impurity-diffusing composition was prepared in the same manner as in Example 1 except that PVA was not used. Components (A) to (C) in the p-type impurity-diffusing composition, contents of components in the hydroxyl group-containing polymer (B), and contents of components in the organic solvent (C) are shown in Table 1.

White precipitation of the above-obtained p-type impurity-diffusing composition generated, failing to obtain a uniform coating solution.

Comparative Example 5

A p-type impurity-diffusing composition was obtained in the same manner as in Example 18 except that EG was used instead of γ-BL. Components (A) to (C) in the p-type impurity-diffusing composition, contents of components in the hydroxyl group-containing polymer (B), and contents of components in the organic solvent (C) are shown in Table 1.

The p-type impurity-diffusing composition obtained above had a bad storage stability when stored at 25°C for 7 days, resulting in gelation.

[Table 1]

| | Group 13 element-containing compound (A) | Hydroxyl group-containing polymer (B) | | | | Organic solvent (C) | | | |
| | | Component 1 | | Component 2 | | Cyclic ester solvent (C1) | | Organic solvent except cyclic ester solvent (C1) | |
| | Components | Name | Content in hydroxyl group-containing polymer (B) (mass%) | Name | Content in hydroxyl group-containing polymer (B) (mass%) | Components | Content in organic solvent (C) (mass%) | Components | Content in organic solvent (C) (mass%) |
|---|---|---|---|---|---|---|---|---|---|
| Example 1 | $B_2O_3$ | PVA | 100 | - | - | $\gamma$-BL | 100 | - | 0 |
| Example 2 | $B_2O_3$ | PVA | 100 | - | - | $\gamma$-BL | 70 | PGME | 30 |
| Example 3 | $B_2O_3$ | PVA | 100 | - | - | $\gamma$-BL | 60 | PGME | 40 |
| Example 4 | $B_2O_3$ | PVA | 100 | - | - | $\gamma$-BL | 40 | PGME | 60 |
| Example 5 | $B_2O_3$ | PVA | 100 | - | - | $\gamma$-BL | 70 | 1-BuOH | 30 |
| Example 6 | Boric acid | PVA | 100 | - | - | $\gamma$-BL | 100 | - | 0 |
| Example 7 | $B_2O_3$ | PVB | 100 | - | - | $\gamma$-BL | 100 | - | 0 |
| Example 8 | $B_2O_3$ | PVA | 100 | - | - | $\delta$-VL | 100 | - | 0 |
| Example 9 | $B_2O_3$ | PVA | 45 | PEO | 55 | $\gamma$-BL | 100 | - | 0 |
| Example 10 | $B_2O_3$ | PVA | 45 | PEO | 55 | $\gamma$-BL | 70 | EG | 30 |
| Example 11 | $B_2O_3$ | PVA | 30 | PEO | 70 | $\gamma$-BL | 100 | - | 0 |
| Example 12 | $B_2O_3$ | PVA | 20 | PEO | 80 | $\gamma$-BL | 100 | - | 0 |
| Example 13 | $B_2O_3$ | PVA | 60 | PEO | 40 | $\gamma$-BL | 100 | - | 0 |
| Example 14 | $B_2O_3$ | PVA | 70 | PEO | 30 | $\gamma$-BL | 100 | - | 0 |
| Example 15 | $B_2O_3$ | PVA | 48 | HEC | 52 | $\gamma$-BL | 100 | - | 0 |
| Example 16 | $B_2O_3$ | PVA | 100 | - | - | $\gamma$-BL | 100 | - | 0 |
| Comparative Example 1 | $B_2O_3$ | PVA | - | - | - | - | 0 | PGME | 100 |
| Comparative Example 2 | $B_2O_3$ | PVA | - | - | - | - | 0 | 1-BuOH | 100 |

(continued)

| | Group 13 element-containing compound (A) | Hydroxyl group-containing polymer (B) | | | | Organic solvent (C) | | | |
| | | Component 1 | | Component 2 | | Cyclic ester solvent (C1) | | Organic solvent except cyclic ester solvent (C1) | |
| | Components | Name | Content in hydroxyl group-containing polymer (B) (mass%) | Name | Content in hydroxyl group-containing polymer (B) (mass%) | Components | Content in organic solvent (C) (mass%) | Components | Content in organic solvent (C) (mass%) |
|---|---|---|---|---|---|---|---|---|---|
| Comparative Example 3 | $B_2O_3$ | PVA | - | - | - | - | 0 | PGMEA | 100 |
| Comparative Example 4 | $B_2O_3$ | - | - | - | - | γ-BL | 100 | - | 0 |
| Comparative Example 5 | $B_2O_3$ | PVA | 100 | - | - | - | 0 | EG | 00 |

[Table 2]

| | Viscosity immediately after preparation (mPa·s) | Viscosity when stored at 25°C for 7 days (mPa·s) | Increase ratio of viscosity (%) | Storage stability | TI value (2rpm/ 20rpm) | Sheet resistance (Ω/□) | Diffusion uniformity | Screen printing property |
|---|---|---|---|---|---|---|---|---|
| Example 1 | 34.8 | 35.2 | 1. 15 | A | - | 80 | A | - |
| Example 2 | 35.5 | 36.1 | 1. 69 | A | - | 81 | A | - |
| Example 3 | 35.6 | 37.9 | 6.46 | B | - | 87 | B | - |
| Example 4 | 35.8 | 38.1 | 6.42 | B | - | 86 | B | - |
| Example 5 | 36.1 | 36.9 | 2.22 | A | - | 80 | A | - |
| Example 6 | 33.2 | 34.3 | 3.31 | A | - | 85 | A | - |
| Example 7 | 32.5 | 35.2 | 8.31 | B | - | 95 | B | - |
| Example 8 | 36.5 | 39.8 | 9.04 | B | - | 92 | B | - |
| Example 9 | 6700 | 6850 | 2.24 | A | 1.59 | 82 | A | A |
| Example 10 | 6980 | 7260 | 4.01 | A | 1. 51 | 79 | A | A |
| Example 11 | 4700 | 4800 | 2.13 | A | 1.19 | 80 | A | A |
| Example 12 | 3200 | 3300 | 3.48 | A | 1.12 | 90 | B | B |
| Example 13 | 10000 | 10400 | 1. 65 | A | 1.62 | 81 | A | A |
| Example 14 | 14300 | 16200 | 8.30 | B | 1.84 | 82 | B | C |
| Example 15 | 9300 | 9980 | 7.31 | B | 2.55 | 91 | B | C |
| Example 16 | 1200 | 1300 | 8.33 | B | 1.08 | 81 | B | C |
| Comparative Example 1 | 38.8 | 51.3 | 32.22 | C | - | 105 | C | - |
| Comparative Example 2 | 37.3 | 50.5 | 35.39 | C | - | 113 | C | - |
| Comparative Example 3 | Cloudy | | | | | | | |
| Comparative Example 4 | White precipitation | | | | | | | |

(continued)

| | Viscosity immediately after preparation (mPa·s) | Viscosity when stored at 25°C for 7 days (mPa·s) | Increase ratio of viscosity (%) | Storage stability | TI value (2rpm/ 20rpm) | Sheet resistance (Ω/□) | Diffusion uniformity | Screen printing property |
|---|---|---|---|---|---|---|---|---|
| Comparative Example 5 | | | Gelation | | | | | |

DESCRIPTION OF REFERENCE SIGNS

1: Semiconductor substrate
2: P-type impurity-diffusing composition film
3: P-type impurity diffusion layer
4: High concentration p-type impurity diffusion layer region
5: Low concentration p-type impurity diffusion layer region
6: N-type impurity-diffusing composition film
7: N-type impurity diffusion layer
8: Barrier layer
8a: Barrier layer opening
9: P-type contact electrode
10: N-type contact electrode
11: Double side power generation type solar cell

**Claims**

1. A p-type impurity-diffusing composition comprising a group 13 element-containing compound (A), a hydroxyl group-containing polymer (B), and an organic solvent (C), wherein the organic solvent (C) comprises a cyclic ester solvent (C1).

2. The p-type impurity-diffusing composition according to claim 1, wherein the content of the cyclic ester solvent (C1) in the organic solvent (C) is in the range of 70 to 100% by mass.

3. The p-type impurity-diffusing composition according to claim 1 or 2, wherein the cyclic ester solvent (C1) is $\gamma$-butyrolactone.

4. The impurity-diffusing composition according to any one of claims 1 to 3, wherein the hydroxyl group-containing polymer (B) comprises polyvinyl alcohol resin (B1) and polyethylene oxide (B2), and the content ratio (mass ratio) of the polyvinyl alcohol resin (B1) and the polyethylene oxide (B2) is expressed by (B1):(B2)=(60:40) to (30:70).

5. The impurity-diffusing composition according to any one of claims 1 to 4, having a viscosity in the range of 3000 to 15000 mPa·s and a thixotropic index (2 rpm/20 rpm) in the range of 1.1 to 1.7.

6. The p-type impurity-diffusing composition according to any one of claims 1 to 5, wherein the group 13 element-containing compound (A) comprises at least one of boron oxide and boric acid.

7. A method of manufacturing a semiconductor device comprising the steps of: applying the p-type impurity-diffusing composition defined in any one of claims 1 to 6 to a semiconductor substrate to form a p-type impurity-diffusing composition film; and diffusing p-type impurities from the p-type impurity-diffusing composition film to the semiconductor substrate to form a p-type impurity diffusion layer on the semiconductor substrate.

8. The method of manufacturing a semiconductor device according to claim 7, wherein applying the p-type impurity-diffusing composition defined in any one of claims 1 to 6 to a semiconductor substrate to form a p-type impurity-diffusing composition film is carried out partially; and wherein the step of diffusing p-type impurities to the semiconductor substrate is carried out by simultaneously heating the p-type impurity-diffusing composition film in a p-type impurity-containing atmosphere, to form a high concentration p-type impurity diffusion layer region and a low concentration p-type impurity diffusion layer region on the semiconductor substrate.

9. The method of manufacturing a semiconductor device according to claim 7 further comprising the steps of: applying an n-type impurity-diffusing composition to the semiconductor substrate to form an n-type impurity-diffusing composition film; and forming a p-type impurity diffusion layer and an n-type impurity diffusion layer on the semiconductor substrate by simultaneously heating the p-type impurity-diffusing composition film and the n-type impurity-diffusing composition film.

**10.** The method of manufacturing a semiconductor device according to claim 7, wherein the p-type impurity-diffusing composition defined in any one of claims 1 to 6 is applied to one side of the semiconductor substrate to form a p-type impurity-diffusing composition film; the method further comprising a step of diffusing an n-type impurity diffusion component to the other side of the semiconductor substrate without removing the p-type impurity-diffusing composition film after diffusing p-type impurities from the p-type impurity-diffusing composition to the semiconductor substrate to form a p-type impurity diffusion layer on the semiconductor substrate.

**11.** The method of manufacturing a semiconductor device according to any one of claims 7 to 10, wherein the method of applying the p-type impurity-diffusing composition to the semiconductor substrate is screen printing.

**12.** A method of manufacturing a solar cell comprising the manufacturing method defined in any one of claims 7 to 11.

**Patentansprüche**

**1.** Zusammensetzung für diffundierende p-Typ-Verunreinigungen, umfassend eine ein Element der Gruppe 13 enthaltende Verbindung (A), ein eine Hydroxylgruppe enthaltendes Polymer (B) und ein organisches Lösungsmittel (C), wobei das organische Lösungsmittel (C) ein zyklisches Esterlösungsmittel (C1) aufweist.

**2.** Zusammensetzung für diffundierende p-Typ-Verunreinigungen nach Anspruch 1, wobei der Gehalt des zyklischen Esterlösungsmittels (C1) in dem organischen Lösungsmittel (C) im Bereich von 70 bis 100 Masse-% liegt.

**3.** Zusammensetzung für diffundierende p-Typ-Verunreinigungen nach Anspruch 1 oder 2, wobei das zyklische Esterlösungsmittel (C1) $\gamma$-Butyrolacton ist.

**4.** Zusammensetzung für diffundierende p-Typ-Verunreinigungen nach einem der Ansprüche 1 bis 3, wobei das eine Hydroxylgruppe enthaltende Polymer (B) ein Polyvinylalkohol-Harz (B1) und ein Poylethylenoxid (B2) umfasst und das Gehaltsverhältnis (Masseverhältnis) des Polyvinylalkohol-Harzes (B1) und des Polyethylenoxids (B2) durch (B1) : (B2) = (60 : 40) bis (30 : 70) ausgedrückt wird.

**5.** Zusammensetzung für diffundierende p-Typ-Verunreinigungen nach einem der Ansprüche 1 bis 4, mit einer Viskosität im Bereich von 3000 bis 15000 mPa·s und einem thixotropischen Index (2 UpM /20 UpM) im Bereich von 1,1 bis 1,7.

**6.** Zusammensetzung für diffundierende p-Typ-Verunreinigungen nach einem der Ansprüche 1 bis 5, wobei die ein Element der Gruppe 13 enthaltende Verbindung (A) Boroxid und/oder Borsäure umfasst.

**7.** Verfahren zum Herstellen einer Halbleitervorrichtung, umfassend die Schritte: Aufbringen der in einem der Ansprüche 1 bis 6 definierten Zusammensetzung für diffundierende p-Typ-Verunreinigungen auf ein Halbleitersubstrat, um einen Film einer Zusammensetzung für diffundierende p-Typ-Verunreinigungen auszubilden; und Diffundieren der p-Typ-Verunreinigungen aus dem Film einer Zusammensetzung für diffundierende p-Typ-Verunreinigungen in das Halbleitersubstrat, um auf dem Halbleitersubstrat eine Diffusionsschicht aus p-Typ-Verunreinigungen auszubilden.

**8.** Verfahren zum Herstellen einer Halblitervorrichtung nach Anspruch 7, wobei ein Aufbringen der in einem der Ansprüche 1 bis 6 definierten Zusammensetzung für diffundierende p-Typ-Verunreinigungen auf ein Halbleitersubstrat, um einen Film einer Zusammensetzung für diffundierende p-Typ-Verunreinigungen auszubilden, partiell ausgeführt wird; und wobei der Schritt eines Diffundierens von p-Typ-Verunreinigungen in das Halbleitersubstrat ausgeführt wird, indem der Film einer Zusammensetzung für diffundierende p-Typ-Verunreinigungen in einer p-Typ-Verunreinigungen enthaltenden Atmosphäre gleichzeitig erhitzt wird, um einen Bereich einer Diffusionsschicht aus p-Typ-Verunreinigungen in hoher Konzentration und einen Bereich einer Diffusionsschicht aus p-Typ-Verunreinigungen in niedriger Konzentration auf dem Halbleitersubstrat auszubilden.

**9.** Verfahren zum Herstellen einer Halbleitervorrichtung nach Anspruch 7, ferner umfassend die Schritte: Aufbringen einer Zusammensetzung für diffundierende n-Typ-Verunreinigungen auf das Halbleitersubstrat, um einen Film einer Zusammensetzung für diffundierende n-Typ-Verunreinigungen auszubilden; und Ausbilden einer Diffusionsschicht aus p-Typ-Verunreinigungen und einer Diffusionsschicht aus n-Typ-Verunreinigungen auf dem Halbleitersubstrat, indem der Film einer Zusammensetzung für diffundierende p-Typ-Verunreinigungen und der Film einer Zusammensetzung für diffundierende n-Typ-Verunreinigungen gleichzeitig erhitzt werden.

**10.** Verfahren zum Herstellen einer Halbleitervorrichtung nach Anspruch 7, wobei die in einem der Ansprüche 1 bis 6 definierte Zusammensetzung für diffundierende p-Typ-Verunreinigungen auf eine Seite des Halbleitersubstrats aufgebracht wird, um einen Film einer Zusammensetzung für diffundierende p-Typ-Verunreinigungen auszubilden; wobei das Verfahren ferner einen Schritt eines Diffundierens einer Diffusionskomponente von n-Typ-Verunreinigungen zu der anderen Seite des Halbleitersubstrats umfasst, ohne den Film einer Zusammensetzung für diffundierende p-Typ-Verunreinigungen zu entfernen, nachdem p-Typ-Verunreinigungen aus der Zusammensetzung für diffundierende p-Typ-Verunreinigungen zum Halbleitersubstrat diffundiert sind, um eine Diffusionsschicht aus p-Typ-Verunreinigungen auf dem Halbleitersubstrat auszubilden.

**11.** Verfahren zum Herstellen einer Halbleitervorrichtung nach einem der Ansprüche 7 bis 10, wobei das Verfahren zum Aufbringen der Zusammensetzung für diffundierende p-Typ-Verunreinigungen auf das Halbleitersubstrat Siebdruck ist.

**12.** Verfahren zum Herstellen einer Solarzelle, umfassend das in einem der Ansprüche 7 bis 11 definierte Herstellungsverfahren.

**Revendications**

**1.** Composition pour la diffusion d'impuretés de type p comprenant un composé (A) contenant un élément du groupe 13, un polymère (B) contenant un groupe hydroxyle et un solvant organique (C), où le solvant organique (C) comprend un solvant ester cyclique (C1).

**2.** Composition pour la diffusion d'impuretés de type p selon la revendication 1, dans laquelle la teneur en solvant ester cyclique (C1) dans le solvant organique (C) se trouve dans la plage allant de 70 à 100% en masse.

**3.** Composition pour la diffusion d'impuretés de type p selon la revendication 1 ou 2, dans laquelle le solvant ester cyclique (C1) est la $\gamma$-butyrolactone.

**4.** Composition pour la diffusion d'impuretés selon l'une quelconque des revendications 1 à 3, dans laquelle le polymère (B) contenant un groupe hydroxyle comprend une résine d'alcool polyvinylique (B1) et un oxyde de polyéthylène (B2) et le rapport de teneur (rapport en masse) entre la résine d'alcool polyvinylique (B1) et l'oxyde de polyéthylène (B2) est exprimé par (B1) : (B2) = (60 : 40) à (30 : 70).

**5.** Composition pour la diffusion d'impuretés selon l'une quelconque des revendications 1 à 4, ayant une viscosité se trouvant dans la plage allant de 3000 à 15000 mPa.s et un indice de thixotropie (2 tr/min/20 tr/min) se trouvant dans la plage allant de 1,1 à 1.7.

**6.** Composition pour la diffusion d'impuretés de type p selon l'une quelconque des revendications 1 à 5, dans laquelle le composé (A) contenant un élément du groupe 13 comprend au moins l'un de l'oxyde de bore et de l'acide borique.

**7.** Procédé de fabrication d'un dispositif à semi-conducteur comprenant les étapes consistant : à appliquer la composition pour la diffusion d'impuretés de type p définie dans l'une quelconque des revendications 1 à 6 sur un substrat semi-conducteur pour former un film de composition pour la diffusion d'impuretés de type p ; et à diffuser les impuretés de type p depuis le film de composition pour la diffusion d'impuretés de type p sur le substrat semi-conducteur pour former une couche de diffusion d'impuretés de type p sur le substrat semi-conducteur.

**8.** Procédé de fabrication d'un dispositif à semi-conducteur selon la revendication 7, dans lequel l'application de la composition pour la diffusion d'impuretés de type p définie dans l'une quelconque des revendications 1 à 6 sur un substrat semi-conducteur pour former un film de composition pour la diffusion d'impuretés de type p est effectuée partiellement ; et dans lequel l'étape de diffusion des impuretés de type p sur le substrat semi-conducteur est effectuée en chauffant simultanément le film de composition pour la diffusion d'impuretés de type p dans une atmosphère contenant des impuretés de type p, pour former une région de couche de diffusion d'impuretés de type p à haute concentration et une région de couche de diffusion d'impuretés de type p à faible concentration sur le substrat semi-conducteur.

**9.** Procédé de fabrication d'un dispositif à semi-conducteur selon la revendication 7, comprenant en outre les étapes consistant : à appliquer une composition pour la diffusion d'impuretés de type n sur le substrat semi-conducteur pour former un film de composition pour la diffusion d'impuretés de type n ; et à former une couche de diffusion d'impuretés de type p et une couche de diffusion d'impuretés de type n sur le substrat semi-conducteur en chauffant simultanément le film de composition pour la diffusion d'impuretés de type p et le film de composition pour la diffusion d'impuretés de type n.

10. Procédé de fabrication d'un dispositif à semi-conducteur selon la revendication 7, dans lequel la composition pour la diffusion d'impuretés de type p définie dans l'une quelconque des revendications 1 à 6 est appliquée sur un côté du substrat semi-conducteur pour former un film de composition pour la diffusion d'impuretés de type p ; le procédé comprenant en outre une étape consistant à diffuser un composant de diffusion d'impuretés de type n sur l'autre côté du substrat semi-conducteur sans retirer le film de composition pour la diffusion d'impuretés de type p après avoir diffusé des impuretés de type p depuis la composition pour la diffusion d'impuretés de type p sur le substrat semi-conducteur pour former une couche de diffusion d'impuretés de type p sur le substrat semi-conducteur.

11. Procédé de fabrication d'un dispositif à semi-conducteur selon l'une quelconque des revendications 7 à 10, dans lequel le procédé d'application de la composition pour la diffusion d'impuretés de type p sur le substrat semi-conducteur est la sérigraphie.

12. Procédé de fabrication d'une cellule solaire comprenant le procédé de fabrication défini dans l'une quelconque des revendications 7 à 11.

[Fig 1]

[Fig 1]

(a) 2 1

(b) 2 1 3

(c) 3 3

[Fig 2]

[Fig 2]

(a)

(b)

(c)

[Fig 3]

[Fig 3]

(a)

(b)

(c)

(d)

[Fig 4]

[Fig 4]

[Fig 5]

[Fig 5]

(e)

(f)

(g)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 9181010 A
- WO 2015002132 A
- JP 2011071489 A
- JP 2012114298 A